(19) Europäisches Patentamt
European Patent Office
Office européen des brevets

(11) EP 2 917 688 B1

(12) FASCICULE DE BREVET EUROPEEN

(45) Date de publication et mention de la délivrance du brevet:
**24.08.2016 Bulletin 2016/34**

(21) Numéro de dépôt: **13763109.9**

(22) Date de dépôt: **19.09.2013**

(51) Int Cl.:
*G01B 11/06* (2006.01)    *G01B 11/30* (2006.01)

(86) Numéro de dépôt international:
**PCT/EP2013/069528**

(87) Numéro de publication internationale:
**WO 2014/072109 (15.05.2014 Gazette 2014/20)**

(54) **PROCEDE DE MESURE DES VARIATIONS D'EPAISSEUR D'UNE COUCHE D'UNE STRUCTURE SEMI-CONDUCTRICE MULTICOUCHE**

VERFAHREN ZUR DICKENVARIATIONSMESSUNG IN EINER SCHICHT EINER MEHRSCHICHTIGEN HALBLEITERSTRUKTUR

METHOD FOR MEASURING THICKNESS VARIATIONS IN A LAYER OF A MULTILAYER SEMICONDUCTOR STRUCTURE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.11.2012 FR 1260751**

(43) Date de publication de la demande:
**16.09.2015 Bulletin 2015/38**

(73) Titulaires:
• **Soitec**
**38190 Bernin (FR)**
• **STMicroelectronics (Crolles 2) SAS**
**38920 Crolles (FR)**

(72) Inventeurs:
• **KONONCHUK, Oleg**
**F-38570 THEYS (FR)**
• **DUTARTRE, Didier**
**F-38240 Meylan (FR)**

(74) Mandataire: **Regimbeau**
**139, rue Vendôme**
**69477 Lyon Cedex 06 (FR)**

(56) Documents cités:
**EP-A1- 2 426 717        US-A- 5 402 001**
**US-A1- 2002 057 437**

**Description**

**DOMAINE DE L'INVENTION**

La présente invention concerne un procédé de mesure des variations d'épaisseur d'une couche d'une structure semi-conductrice multicouche, ainsi qu'un système permettant la mise en oeuvre dudit procédé.

**ARRIERE PLAN DE L'INVENTION**

Dans le domaine de l'électronique, des structures semi-conductrices multicouches sont fréquemment utilisées.

Un exemple particulier de telles structures est une structure de type semi-conducteur sur isolant (SeOI, acronyme du terme anglo-saxon « Semiconductor On Insulator »).

Une structure de type SeOI comprend typiquement de sa base vers sa surface un substrat support, une couche électriquement isolante et une couche mince semi-conductrice, dite couche active, dans ou sur laquelle sont généralement destinés à être formés des composants électroniques.

Lorsque la couche mince est en silicium, la structure est désignée par le terme SOI, acronyme du terme anglo-saxon « Silicon On Insulator ».

La couche électriquement isolante est en un matériau diélectrique, notamment un oxyde du matériau du substrat support et/ou de la couche mince. Cette couche est alors usuellement désignée par le terme BOX, acronyme du terme anglo-saxon « Buried OXide » ou oxyde enterré.

Récemment, des structures SOI présentant une couche extra-mince de silicium ont été développées.

Ces structures sont désignées par le terme « FDSOI », pour « Fully Depleted SOI », c'est-à-dire SOI totalement déserté.

Par « ultra-mince » on entend une épaisseur inférieure ou égale à 50 nm, de préférence inférieure ou égale à 12 nm, pouvant même être réduite jusqu'à 5 nm environ.

Les structures FDSOI sont particulièrement avantageuses pour la réalisation de composants électroniques planaires, par exemple des transistors FDMOS (acronyme de « Fully Depleted Metal Oxide Semiconductor »), dont le canal est formé dans ou sur la couche mince de silicium.

Du fait de l'extrême finesse de l'épaisseur de ladite couche mince, la tension de seuil du transistor (usuellement notée Vt), qui dépend de cette épaisseur, est très sensible aux variations d'épaisseur de la couche mince.

Pour de telles applications, on recherche donc une uniformité optimale de la couche mince de silicium de sorte à avoir une variabilité de Vt minimale d'un transistor à l'autre.

Compte tenu des faibles dimensions de ces dispositifs et de leur grande proximité, il est nécessaire de mesurer la variation d'épaisseur entre des points très proches les uns des autres, par exemple tous les 0,5 $\mu$m.

Ceci implique, au cours du procédé de fabrication du SOI, de mesurer l'épaisseur de la couche mince de silicium et de la couche électriquement isolante, en différents points de la surface du SOI, dans une large gamme de longueurs d'ondes spatiales, typiquement comprises entre 0,5 $\mu$m et 300 mm.

Les procédés de mesure actuels reposent sur des mesures optiques, notamment l'ellipsométrie ou la réflectométrie spectrale.

Dans les deux cas, ces procédés impliquent de réaliser un grand nombre de mesures en illuminant le SOI avec un flux lumineux présentant différentes longueurs d'onde optiques, de sorte à mesurer non seulement l'épaisseur de la couche de silicium mais également celle de la couche d'oxyde enterré.

Cependant, ces techniques ne permettent pas d'effectuer des mesures avec des longueurs d'onde spatiales aussi faibles que 0,5 $\mu$m.

Ainsi, un ellipsomètre permet de réaliser des mesures avec des longueurs d'onde spatiales supérieures ou égale à 40 $\mu$m environ.

D'autre part, ces mesures sont longues et pénalisent le cycle de fabrication des SOI.

Par ailleurs, des mesures effectuées par ellipsométrie ou réflectométrie avec une longueur d'onde optique unique ne permettraient pas de déterminer avec une précision suffisante l'épaisseur de la couche de silicium, car, pour une longueur d'onde optique donnée, l'épaisseur mesurée de la couche de silicium dépend de l'épaisseur et de la nature de la couche d'oxyde enterré sous-jacente.

On connaît du document EP2426717 une optimisation du choix de la longueur d'onde pour obtenir un maximum de la sensibilité de la réflectivité par rapport au variations de l'épaisseur de la couche d'intérêt dans une structure multicouche. Le document US5402001 décrit un procédé de minimisation de l'influence des variations de l'épaisseur d'une couche sur les mesures des défauts par diffusion.

Un but de l'invention est donc de proposer un procédé de mesure des variations d'épaisseur d'une couche d'une structure semi-conductrice multicouche, qui permette d'effectuer des mesures en particulier dans la gamme des longueurs d'onde spatiales comprises entre 0,5 et 40 $\mu$m, qui n'est pas accessible avec les méthodes de mesure actuelles.

En particulier, ledit procédé devra permettre de mesurer les variations d'épaisseur de la couche mince de silicium d'une structure FDSOI, avec une précision au moins égale à 0,1 nm.

## BREVE DESCRIPTION DE L'INVENTION

Conformément à l'invention, il est proposé un procédé de mesure des variations d'épaisseur d'une couche d'une structure semi-conductrice multicouche, qui comprend :

- l'acquisition, par un système d'acquisition d'image, d'au moins une image de la surface de ladite structure, ladite image étant obtenue par réflexion d'un flux lumineux quasi-monochromatique sur la surface de ladite structure,
- le traitement de ladite au moins une image acquise de sorte à déterminer, à partir des variations d'intensité de la lumière réfléchie par ladite surface, les variations de l'épaisseur de ladite couche à mesurer,

la longueur d'onde dudit flux lumineux quasi-monochromatique étant choisie de sorte à correspondre à un minimum de la sensibilité de la réflectivité de la structure multicouche par rapport à une couche de la structure autre que la couche dont les variations d'épaisseur doivent être mesurées.

La sensibilité de la réflectivité par rapport à une couche de la structure, qui est homogène à l'inverse d'une longueur, est définie comme étant le rapport entre :

- la différence entre les réflectivités de deux structures multicouches pour lesquelles la couche considérée présente une différence d'épaisseur donnée d'une structure à l'autre (par exemple 0,1 nm) et
- ladite différence d'épaisseur donnée,

les épaisseurs des autres couches étant quant à elles identiques dans les deux structures.

En d'autres termes, les deux structures visées ci-dessus sont constituées des mêmes couches, lesdites couches présentant la même épaisseur dans les deux structures, à l'exception de la couche pour laquelle on souhaite mesurer la sensibilité de la réflectivité et à laquelle on affecte une épaisseur différente d'une structure à l'autre.

Cette sensibilité de la réflectivité dépend de la longueur d'onde du flux lumineux employé pour la mesure.

Pour la mise en oeuvre de l'invention, on s'intéresse à la valeur absolue de ladite sensibilité, la sensibilité minimale recherchée par rapport à une couche autre que la couche à mesurer étant nulle ou proche de 0.

Par « structure multicouche » on entend une structure comprenant au moins deux couches qui sont transparentes à la longueur d'onde du flux quasi-monochromatique de mesure.

Par « quasi-monochromatique » on entend un flux lumineux dont le spectre s'étend dans un intervalle de longueur d'onde pouvant s'étendre jusqu'à +/-20 nm par rapport à une longueur d'onde nominale. Lorsque l'on parle de la longueur d'onde dudit flux quasi-monochromatique, on fait référence à la longueur d'onde nominale. Naturellement, un flux lumineux monochromatique, c'est-à-dire présentant une unique longueur d'onde, peut également être utilisé pour mettre en oeuvre l'invention.

Selon une forme d'exécution de l'invention, ledit système d'acquisition d'image est un microscope optique.

Selon une autre forme d'exécution, ledit système d'acquisition d'image est un appareil photographique numérique dont la taille d'un pixel est inférieure ou égale à 0,25 $\mu$m.

De préférence, l'ouverture numérique du système d'acquisition d'image est supérieure ou égale à 0,8.

L'incidence du flux lumineux sur la surface de la structure est avantageusement normale à ladite surface.

Selon un mode de réalisation, ledit traitement comprend un calcul d'une réflectivité théorique de la structure multicouche en fonction de l'épaisseur de ladite couche à mesurer pour la longueur d'onde du flux lumineux quasi-monochromatique et la détermination, à partir dudit calcul, d'une cartographie des variations d'épaisseur de ladite couche.

Selon un mode de réalisation, ledit traitement comprend :

- la comparaison de l'image avec une courbe de calibration préalablement établie, ladite courbe de calibration fournissant une relation entre des niveaux de gris de l'image acquise et une épaisseur locale de ladite couche à mesurer, et
- la détermination, à partir de ladite courbe de calibration, d'une cartographie des variations d'épaisseur de la couche sur la surface de la structure.

De manière avantageuse, le procédé comprend, préalablement à l'acquisition de ladite au moins une image, les étapes suivantes :

- mesure de l'épaisseur de chacune des couches de la structure,
- à partir de ladite épaisseur mesurée, simulation de la sensibilité de la réflectivité par rapport à chacune desdites couches en fonction de la longueur d'onde d'un flux lumineux incident, et

- détermination, à partir de ladite simulation, de la longueur d'onde du flux lumineux quasi-monochromatique destiné à illuminer la surface de la structure, ladite longueur d'onde étant choisie de sorte à minimiser la sensibilité de la réflectivité par rapport à une couche autre que la couche à mesurer.

Ladite mesure d'épaisseur est avantageusement réalisée au moyen d'un ellipsomètre ou d'un réflectomètre.

Selon une application particulière de l'invention, la structure multicouche est une structure constituée de deux couches transparentes à la longueur d'onde du flux lumineux quasi-monochromatique sur un substrat support.

De manière particulièrement avantageuse, ladite structure multicouche est une structure semi-conducteur sur isolant comprenant un substrat support, une couche électriquement isolante et une couche semi-conductrice et la couche dont on mesure les variations d'épaisseur est ladite couche semi-conductrice.

Par exemple, ladite structure est avantageusement une structure FDSOI, la couche dont on mesure les variations d'épaisseur étant une couche de silicium présentant une épaisseur inférieure ou égale à 50 nm, de préférence inférieure ou égale à 12 nm.

Un autre objet concerne un système de mesure permettant la mise en oeuvre du procédé décrit ci-dessus.

Ledit système de mesure des variations d'épaisseur d'une couche d'une structure semi-conductrice multicouche comprend :

- un dispositif d'éclairage de la structure, adapté pour émettre un flux lumineux quasi-monochromatique en direction de la surface de ladite structure,
- un dispositif de sélection de la longueur d'onde du flux lumineux quasi-monochromatique configuré pour déterminer une longueur d'onde correspondant à un minimum de la sensibilité de la réflectivité par rapport à une couche de la structure autre que la couche dont les variations d'épaisseur doivent être mesurées, ladite sensibilité de la réflectivité par rapport à une couche étant égale au rapport entre :

  - la différence entre les réflectivités de deux structures multicouches pour lesquelles la couche considérée présente une différence d'épaisseur donnée et
  - ladite différence d'épaisseur donnée,
    les épaisseurs des autres couches étant quant à elles identiques dans les deux structures multicouches,
    ledit dispositif de sélection étant couplé au dispositif d'éclairage pour fournir audit dispositif d'éclairage ladite longueur d'onde déterminée du flux lumineux à émettre,

- un système d'acquisition d'image agencé de sorte à acquérir au moins une image de la surface de la structure par réflexion dudit flux lumineux quasi-monochromatique,
- un système de traitement configuré pour, à partir de ladite au moins une image acquise, déterminer, à partir des variations d'intensité de la lumière réfléchie par ladite surface, les variations de l'épaisseur de ladite couche à mesurer.

Selon un mode de réalisation, le dispositif d'éclairage comprend une source de lumière blanche et une roue supportant une pluralité de filtres présentant des longueurs d'onde différentes, la roue étant adaptée pour tourner de sorte que la lumière émise par ladite source passe au travers d'un filtre présentant la longueur d'onde déterminée par le dispositif de sélection avant d'atteindre la surface de la structure à mesurer.

Selon un autre mode de réalisation, le dispositif d'éclairage comprend une pluralité de sources lumineuses présentant chacune une longueur d'onde différente et une pluralité d'obturateurs amovibles couplés auxdites sources et agencés de sorte à ne laisser passer que la lumière présentant la longueur d'onde déterminée par le dispositif de sélection vers la surface de la structure à mesurer.

BREVE DESCRIPTION DES DESSINS

D'autres caractéristiques et avantages de l'invention ressortiront de la description détaillée qui va suivre, en référence aux dessins annexés sur lesquels :

- la figure 1 est une vue en coupe d'une structure multicouche dont on cherche à mesurer les variations d'épaisseur de l'une des couches,
- la figure 2 illustre de manière schématique les réflexions se produisant dans deux couches d'une structure multicouche,
- la figure 3 présente les courbes de la sensibilité de la réflectivité d'une structure FDSOI, en fonction de la longueur d'onde, par rapport à la couche mince de silicium (courbes Si1 et Si2) et par rapport à la couche d'oxyde enterré (courbes BOX1 et BOX2),

- la figure 4 présente une courbe de calibration d'un microscope optique susceptible d'être mis en oeuvre dans l'invention,
- les figures 5A et 5B illustrent les images de microscopie optique acquises pour deux structures FDSOI et les figures 5C et 5D présentent les cartographies d'épaisseur de la couche mince de silicium obtenues respectivement pour chacune desdites structures,
- la figure 6 illustre un mode de réalisation d'un dispositif d'éclairage appartenant à un système de mesure selon l'invention,
- la figure 7 illustre un autre mode de réalisation d'un dispositif d'éclairage appartenant à un système de mesure selon l'invention.

## DESCRIPTION DETAILLEE DE L'INVENTION

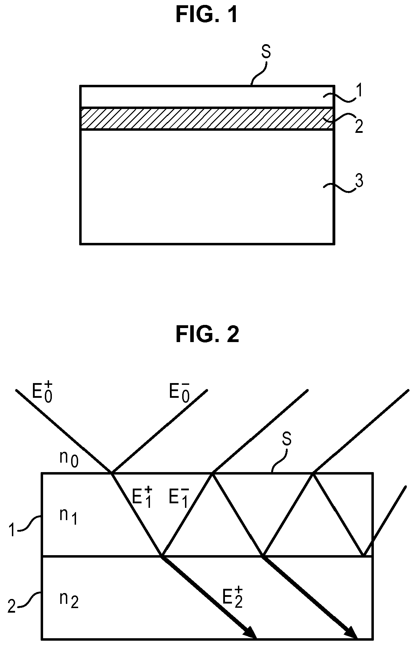

La figure 1 illustre une structure multicouche pour laquelle on souhaite mesurer les variations d'épaisseur de l'une des couches.

La structure comprend successivement de sa surface S vers sa base une première couche 1, une deuxième couche 2 et un substrat support 3.

La première et la deuxième couche sont dans des matériaux choisis de sorte à être transparents à la longueur d'onde de mesure, c'est-à-dire que le flux lumineux incident est apte à traverser chacune desdites couches et à se réfléchir partiellement sur la surface de la couche sous-jacente.

De manière générale, les matériaux semi-conducteurs et les matériaux diélectriques présentent cette propriété, sous réserve de présenter une épaisseur suffisamment fine, c'est-à-dire typiquement inférieure à 500 nm.

Une couche métallique très fine (c'est-à-dire présentant une épaisseur inférieure à 200 nm) pourrait également être mise en oeuvre dans une telle structure multicouche.

L'homme du métier est en mesure de déterminer, pour les matériaux usuellement employés dans le domaine de l'électronique, les épaisseurs maximales pour lesquels ils sont transparents à une longueur d'onde donnée.

Le substrat support joue en revanche un rôle de support mécanique et est généralement trop épais (typiquement, quelques centaines de μm) pour être transparent à la longueur d'onde de mesure.

Ledit substrat support peut être massif ou bien constitué d'une pluralité de couches de matériaux différents.

Dans l'exemple illustré à la figure 1, la structure est donc une structure bicouche, le substrat support n'étant pas considéré comme une couche dont on peut mesurer les variations d'épaisseur.

Néanmoins, l'invention n'est pas limitée à une telle structure mais peut également s'appliquer à une structure comprenant trois couches transparentes à la longueur d'onde de mesure, voire davantage.

Selon une application avantageuse de l'invention, la structure est une structure de type semi-conducteur sur isolant, dans laquelle le substrat support est le substrat 3, la couche électriquement isolante est la couche enterrée 2, et la couche semi-conductrice est la couche superficielle 1.

Selon un mode de réalisation, la couche dont on mesure les variations d'épaisseur est la couche semi-conductrice superficielle 1.

Dans le cas particulier d'une structure FDSOI, la couche dont on mesure les variations d'épaisseur est la couche superficielle 1, qui est une couche de silicium présentant une épaisseur inférieure ou égale à 50 nm, de préférence inférieure ou égale à 12 nm.

La figure 2 illustre de manière schématique les réflexions se produisant dans deux couches d'une structure multicouche (le substrat support n'a pas été représenté).

Un rayon incident sur la surface S est partiellement réfléchi sur ladite surface et partiellement transmis à travers la première couche 1.

Cette portion du faisceau est à son tour partiellement réfléchie à l'interface entre les couches 1 et 2, et partiellement transmise à travers la deuxième couche 2.

Les couches 1 et 2 présentent des indices de réfraction différents, notés respectivement n1 et n2.

Il est possible d'exprimer de manière matricielle la réflectivité d'un tel empilement des couches 1 et 2.

L'équation :

$$\begin{bmatrix} E_0^+ \\ E_0^- \end{bmatrix} = S \begin{bmatrix} E_{m+1}^+ \\ E_{m+1}^- \end{bmatrix}$$

où $E_0^+$ et $E_0^-$ sont les composantes du champ électrique incident et réfléchi sur la couche 1, S est la matrice de diffusion et $E_{m+1}^{+}$ et $E_{m+1}^{-}$ sont les composantes du champ électrique incident et réfléchi sur la couche m+1, m+1 étant égal au nombre de couches de la structure multicouche (l'indice 0 correspondant au milieu entourant la structure), peut s'écrire sous la forme :

$$S = \begin{bmatrix} S_{11} & S_{12} \\ S_{21} & S_{22} \end{bmatrix} = \left( \prod_{\nu=1}^{m} I_{(\nu-1)\nu} L_{\nu} \right) . I_{m(m+1)}$$

où

$$L_j = \begin{bmatrix} e^{-i\xi_j d_j} & 0 \\ 0 & e^{i\xi_j d_j} \end{bmatrix}, I_{jk} = \frac{1}{t_{jk}} \begin{bmatrix} 1 & r_{jk} \\ r_{jk} & 1 \end{bmatrix}, \xi_j = \frac{2\pi}{\lambda} q_j,$$

$q_j = \tilde{n}_j cos\phi_j = \left[ \tilde{n}_j^2 - \tilde{n}_0^2 sin\phi_0 \right]^{1/2}$, j est un entier compris entre 1 et m+1, $\Phi_0$ et $\Phi_j$ sont respectivement l'angle d'incidence sur la surface S de la structure multicouche et de réflexion sur la surface de la couche j.

Les coefficients complexes de Fresnel de réflexion $r_{jk}$ et de transmission $t_{jk}$ sont définis par les formules suivantes :

- pour la polarisation s (perpendiculaire au plan d'incidence) :

$$r_{jk} = \frac{q_j - q_k}{q_j + q_k} \text{ et } t_{jk} = \frac{2q_j}{q_j + q_k}$$

- pour la polarisation p (dans le plan d'incidence) :

$$r_{jk} = \frac{\tilde{n}_k^2 q_j - \tilde{n}_j^2 q_k}{\tilde{n}_k^2 q_j + \tilde{n}_j^2 q_k} \text{ et } t_{jk} = \frac{2\tilde{n}_j \tilde{n}_k q_j}{\tilde{n}_k^2 q_j + \tilde{n}_j^2 q_k}$$

Ces coefficients permettent de simuler la réflectivité de l'empilement des couches 1 et 2 pour une condition d'éclairement donnée.

La réflectivité de l'empilement des couches 1 et 2 dépend de plusieurs paramètres : l'épaisseur de chacune des couches, la polarisation du flux lumineux incident, l'angle d'incidence et la longueur d'onde du flux lumineux.

Pour une structure présentant des couches 1 et 2 d'épaisseurs données, les inventeurs ont défini une grandeur, dite sensibilité de la réflectivité, représentative de l'influence sur la réflectivité de la structure des variations d'épaisseur de chacune des couches.

La sensibilité de la réflectivité par rapport à une couche de la structure multicouche est définie comme étant le rapport entre :

- la différence entre les réflectivités de deux structures multicouches pour lesquelles la couche considérée présente une différence d'épaisseur donnée d'une structure à l'autre, les épaisseurs des autres couches étant quant à elles identiques dans les deux structures, et
- ladite différence d'épaisseur.

La différence d'épaisseur est choisie selon le degré de précision de la mesure que l'on souhaite effectuer ; plus cette différence d'épaisseur est faible, plus il est possible de déterminer précisément la longueur d'onde de mesure optimale.

A titre indicatif, on pourra choisir une différence d'épaisseur de 0,1 nm.

En d'autres termes, la sensibilité de la réflectivité par rapport à une couche correspond à la dérivée partielle de la courbe de réflectivité par rapport à l'épaisseur de la couche considérée, les autres couches de la structure ayant une épaisseur fixée.

Par exemple, pour une structure de type SOI telle qu'illustrée à la figure 1, on calcule la sensibilité de la réflectivité par rapport à la couche semi-conductrice 1 en fixant l'épaisseur de la couche d'oxyde enterrée 2 et en déterminant la réflectivité de la structure pour deux épaisseurs différentes de la couche semi-conductrice 1, la différence entre ces deux épaisseurs étant par exemple de 0,1 nm.

Pour la même structure, on définit la sensibilité de la réflectivité par rapport à la couche d'oxyde enterrée 2 en fixant l'épaisseur de la couche semi-conductrice 1 et en déterminant la réflectivité de la structure pour deux épaisseurs différentes de la couche d'oxyde enterrée 2, la différence entre ces deux épaisseurs étant par exemple de 0,1 nm.

Dans le cas d'un empilement de trois couches transparentes à la longueur d'onde de mesure, l'homme du métier est en mesure de déterminer sur le même principe les coefficients de Fresnel.

Notamment, dans le cas où la structure comprend une couche superficielle dont on souhaite connaître les variations d'épaisseur et deux couches transparentes sous-jacentes, il est possible d'assimiler ces deux couches à une couche unique présentant une réflectivité et une sensibilité qui peuvent être calculés à partir de ceux desdites deux couches.

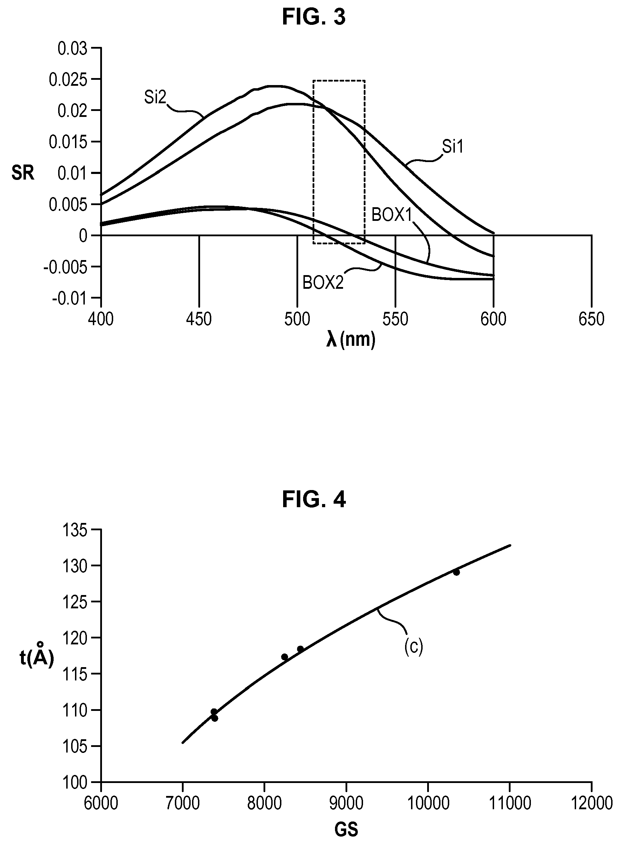

La figure 3 illustre les courbes de la sensibilité de la réflectivité (notée SR, exprimée en Å$^{-1}$) d'une structure FDSOI en fonction de la longueur d'onde $\lambda$ avec une lumière non polarisée calculées par rapport à la couche de silicium (courbes Si1 et Si2) et par rapport à la couche d'oxyde enterrée (courbes BOX1 et BOX2), pour une variation d'épaisseur de 0,1 nm de la couche considérée.

Dans cette structure, la couche de silicium présente une épaisseur de 12 nm d'épaisseur environ et la couche d'oxyde enterrée une épaisseur de 25 nm environ.

Le rectangle en pointillés apparaissant sur ce graphe indique une gamme de longueur d'onde optimale pour éclairer la structure et acquérir une image de la lumière réfléchie afin de déterminer les variations d'épaisseur de la couche de silicium.

En effet, dans cet intervalle, la sensibilité de la réflectivité par rapport à la couche d'oxyde enterrée est, en valeur absolue, minimale (courbes BOX1 et BOX2 passant par 0).

Ceci signifie que la variation de réflectivité mesurée avec un flux lumineux quasi-monochromatique dans cet intervalle de longueur d'onde (se traduisant, sur une image de la surface, par des variations d'intensité des pixels) dépend essentiellement des variations d'épaisseur de la couche de silicium à mesurer.

Il est donc possible de déterminer, à partir des variations d'intensité de la lumière réfléchie par la surface de la structure, les variations d'épaisseur de la couche à mesurer.

Dans l'exemple illustré, la longueur d'onde optimale du flux lumineux est comprise entre 510 et 530 nm environ.

Un filtre interférentiel, quasi-monochromatique autour de 515 nm, peut donc être choisi pour former le flux lumineux incident.

De manière avantageuse, le flux incident sur la surface S de la structure est normal à celle-ci, cette configuration simplifiant le traitement ultérieur de l'image.

Cependant, il est possible, moyennant des traitements complémentaires à la portée de l'homme du métier, d'exploiter une image acquise par réflexion d'un flux lumineux non normal à la surface de la structure.

Pour l'acquisition d'au moins une image de la surface, différents systèmes d'acquisition d'image peuvent être employés.

De préférence, l'ouverture numérique du système d'acquisition est d'au moins 0,8.

Selon une forme d'exécution de l'invention, ledit système d'acquisition comprend un microscope optique présentant un mode de réflexion, c'est-à-dire permettant d'illuminer la structure multicouche par sa surface S à observer.

Le système comprend en outre un capteur apte à acquérir une image de la surface vue par le microscope.

Selon une autre forme d'exécution de l'invention, ledit système d'acquisition comprend un appareil photographique numérique, et permet d'acquérir directement une image de la surface de la structure sur laquelle se réfléchit le flux lumineux incident.

Pour que la résolution d'un tel appareil soit suffisante, on considère que la taille des pixels doit être inférieure ou égale à 0,25 $\mu$m. En d'autres termes, un pixel de l'appareil doit correspondre à une surface de 0,25 $\mu$m de côté ou moins sur la surface de la structure.

Le microscope et l'appareil photographique permettent d'obtenir des longueurs d'onde spatiales jusqu'à 0,5 $\mu$m, ce qui permet de déterminer suffisamment finement les variations d'épaisseur sur la surface de la structure.

Les images acquises par le système d'acquisition sont typiquement des images en noir et blanc présentant différents niveaux de gris.

On calibre le système d'acquisition pour faire correspondre chaque niveau de gris (intensité de chaque pixel) avec une épaisseur correspondante de la couche à mesurer.

A cet effet, à partir de plusieurs structures de même nature, on acquiert des images de la surface par réflexion du flux lumineux quasi-monochromatique et, sur ces mêmes structures, on réalise une mesure par ellipsométrie de la couche dont on souhaite mesurer les variations d'épaisseur.

On obtient ainsi une courbe de calibration du type de celle illustrée à la figure 4, qui présente les épaisseurs mesurées par ellipsométrie en fonction des niveaux de gris de l'image acquise. Sur cette figure, les niveaux de gris correspondent à une échelle arbitraire.

Pour construire la courbe de la figure 4, on a mesuré par ellipsométrie l'épaisseur de la couche de silicium de 5 structures FDSOI dont la couche de silicium présentait une épaisseur comprise entre 11 et 13 nm.

On a par ailleurs acquis des images de la surface de ces structures avec un flux incident quasi-monochromatique de 540 nm et mesuré l'intensité des pixels de ces images.

Il a ainsi été possible d'associer une épaisseur déterminée au niveau de gris correspondant sur l'image.

Les points de mesure ont ensuite servi de base à la définition d'une courbe théorique (c).

Une fois cette calibration effectuée, il est possible de réaliser, à partir de l'intensité des différents pixels d'une image, une cartographie de l'épaisseur de la couche dont on souhaite mesurer les variations d'épaisseur.

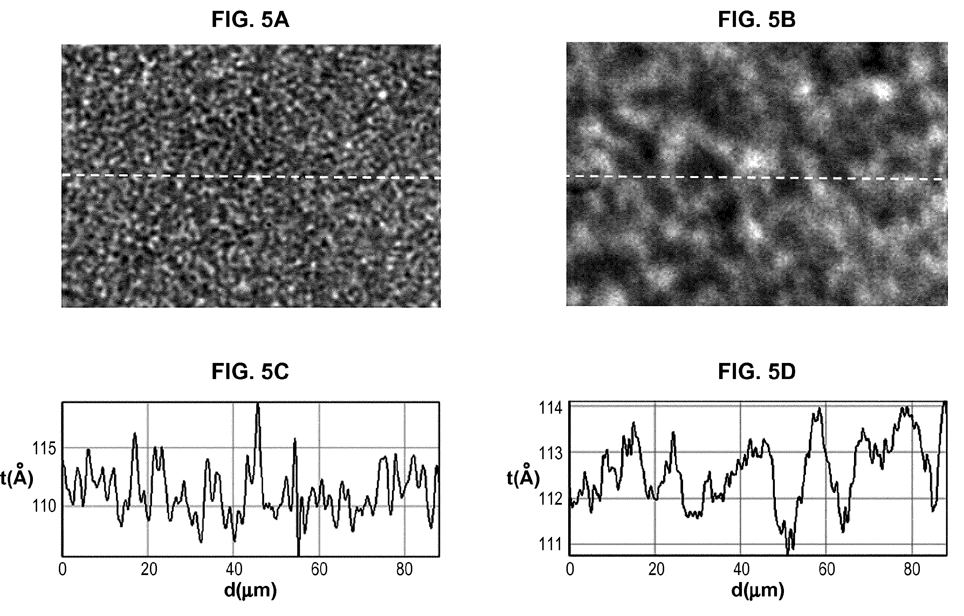

Les figures 5A et 5B présentent ainsi deux exemples d'images acquises au moyen d'un microscope optique du modèle Axiotron2 en mode réflexion, comprenant un objectif présentant une ouverture numérique de 0,9 et un grossissement de 100 fois.

Les figures 5C et 5D présentent respectivement les variations de l'épaisseur t (exprimée en Å (0,1 nm)) en fonction de la distance d (exprimée en $\mu$m) par rapport à un point de référence situé, dans ce cas, sur le bord gauche de l'image microscopique.

Le système de mesure comprend à cet effet un système de traitement configuré pour, sur une image acquise, déterminer, à partir des variations d'intensité de la lumière réfléchie par la surface, les variations de l'épaisseur de ladite couche à mesurer.

Le système de traitement peut ainsi comprendre un ordinateur doté d'un microprocesseur et d'une mémoire sur laquelle est enregistré un programme exécutable par le microprocesseur et contenant des instructions pour mettre en oeuvre les étapes de calcul mentionnées ci-dessus.

Le système de traitement peut en outre comprendre un écran pour afficher une cartographie des variations d'épaisseur de la couche à mesurer.

Par ailleurs, le système de mesure comprend en outre un dispositif de sélection de la longueur d'onde du flux lumineux quasi-monochromatique configuré pour déterminer une longueur d'onde correspondant à un minimum de la sensibilité de la réflectivité par rapport à une couche de la structure autre que la couche dont les variations d'épaisseur doivent être mesurées.

De manière avantageuse, le système de traitement décrit plus haut est lui-même configuré pour simuler la réponse optique d'une structure multicouche et choisir automatiquement la longueur d'onde du flux lumineux quasi-monochromatique adéquat.

A cet effet, le système de mesure comprend en outre un ellipsomètre ou un réflectomètre, qui est utilisé pour mesurer, de manière classique, l'épaisseur de chacune des couches de la structure à partir de la réflectivité desdites couches.

De manière alternative ou complémentaire, le système de mesure comprend une interface graphique sur laquelle un utilisateur entre les caractéristiques de la structure considérée (matériau et épaisseur des différentes couches).

Connaissant ces épaisseurs, le système de traitement met en oeuvre une simulation de la sensibilité de la réflectivité par rapport à chacune des couches de la structure en fonction de la longueur d'onde d'un flux lumineux d'éclairement et en déduit un intervalle de longueur d'onde dans lequel la sensibilité de la réflectivité par rapport à la(aux) couche(s) de la structure autre(s) que la couche dont on souhaite mesurer les variations d'épaisseur est, en valeur absolue, minimale.

Le dispositif de sélection est alors en mesure de fournir la longueur d'onde ainsi déterminée à un dispositif d'éclairage afin que celui-ci éclaire la structure à mesurer avec un flux lumineux quasi-monochromatique présentant la longueur d'onde souhaitée.

On acquiert alors au une moins une image de la surface par réflexion dudit flux lumineux.

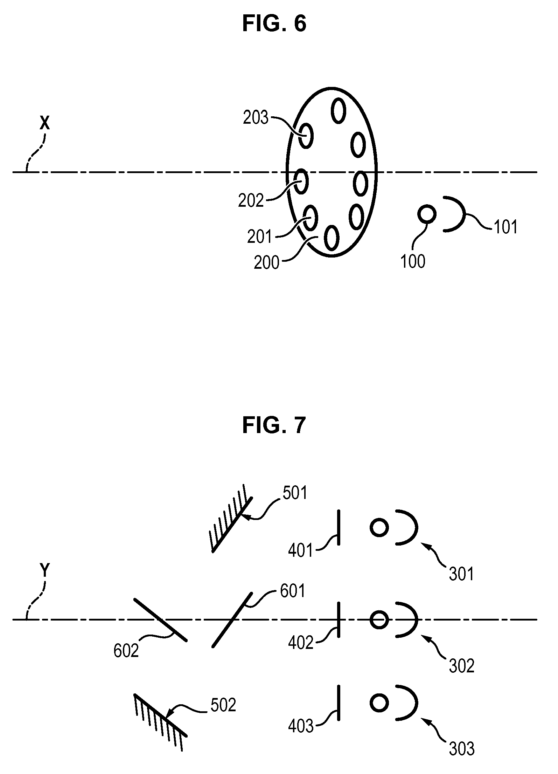

La figure 6 illustre un mode de réalisation d'un dispositif d'éclairage qui pouvant faire partie du système de mesure selon l'invention.

Le dispositif d'éclairage comprend une source 100 de lumière blanche associée à un réflecteur 101 et une roue 200 supportant une pluralité de filtres 201, 202, 203 etc.

La roue est mobile en rotation autour d'un axe X de sorte à positionner, sur le trajet de la lumière émise par la source 100 et renvoyée par le réflecteur 101 en direction de la structure à mesurer (non représentée sur cette figure), le filtre présentant la longueur d'onde adéquate pour minimiser la sensibilité de la réflectivité par rapport à une couche de la structure autre que la couche dont les variations d'épaisseur doivent être mesurées.

A cet égard, le dispositif d'éclairage est couplé au dispositif de sélection de la longueur d'onde pour imposer une rotation de la roue 200 en fonction de la longueur d'onde sélectionnée.

La figure 7 illustre un autre mode de réalisation du dispositif d'éclairage.

Dans celui-ci, le dispositif d'éclairage comprend une pluralité de sources lumineuses 301, 302, 303 (le nombre de sources n'étant pas limitatif), chaque source présentant une longueur d'onde différente.

Chaque source est couplée à un obturateur amovible 401, 402, 403.

En position d'obturation, chaque obturateur est interposé sur la trajectoire de la lumière émise par chaque source, de sorte à empêcher la transmission de lumière vers la structure à mesurer.

Le dispositif d'éclairage est par ailleurs couplé au dispositif de sélection de la longueur d'onde pour déplacer l'un des obturateurs en fonction de la longueur d'onde sélectionnée, afin de permettre l'éclairage de la structure à mesurer par la source lumineuse correspondante.

Le dispositif d'éclairage comprend en outre, entre la structure à mesurer et l'ensemble de sources, un dispositif optique comprenant deux miroirs 501, 502 et deux lames semi-réfléchissantes 601, 602.

Les lames semi-réfléchissantes sont agencées symétriquement l'une par rapport à l'autre sur l'axe optique Y.

Les miroirs sont quant à eux agencés parallèlement à une lame semi-réfléchissante respective, à distance de l'axe optique Y.

Chaque lame semi-réfléchissante laisse passer la moitié de la lumière incidente.

Ainsi, si l'obturateur 401 est ouvert, la lumière émise par la source 301 est réfléchie par le miroir 501 puis est pour moitié transmise au travers de ladite lame 601 et pour moitié réfléchie par la lame semi-réfléchissante 601, cette seconde moitié passant au travers de la lame semi-réfléchissante 602.

Eventuellement, des variantes ou des combinaisons de ces modes de réalisation sont possibles, par exemple l'utilisation d'une pluralité de sources lumineuses chacune associée à une roue porte-filtre.

Enfin, il va de soi que les exemples que l'on vient de donner ne sont que des illustrations particulières en aucun cas limitatives quant aux domaines d'application de l'invention. Notamment, si l'invention s'applique avantageusement à la mesure des variations d'épaisseur d'une structure de type FDSOI, elle n'est pas limitée à une telle structure mais à toute structure multicouche comprenant au moins deux couches transparentes au flux lumineux quasi-monochromatique employé pour la mesure.

## Revendications

1. Procédé de mesure des variations d'épaisseur d'une couche d'une structure semi-conductrice multicouche, **caractérisé en ce qu'**il comprend :

   - l'acquisition, par un système d'acquisition d'image, d'au moins une image de la surface de ladite structure, ladite image étant obtenue par réflexion d'un flux lumineux quasi-monochromatique sur la surface de ladite structure,
   - le traitement de ladite au moins une image acquise de sorte à déterminer, à partir des variations d'intensité de la lumière réfléchie par ladite surface, les variations de l'épaisseur de ladite couche à mesurer,

   et **en ce que** la longueur d'onde dudit flux lumineux quasi-monochromatique est choisie de sorte à correspondre à un minimum de la sensibilité de la réflectivité par rapport à une couche de la structure autre que la couche dont les variations d'épaisseur doivent être mesurées, ladite sensibilité de la réflectivité par rapport à une couche étant égale au rapport entre :

   - la différence entre les réflectivités de deux structures multicouches pour lesquelles la couche considérée présente une différence d'épaisseur donnée et
   - ladite différence d'épaisseur donnée,

   les épaisseurs des autres couches étant quant à elles identiques dans les deux structures multicouches.

2. Procédé selon la revendication 1, **caractérisé en ce que** ledit système d'acquisition d'image est un microscope optique.

3. Procédé selon la revendication 1, **caractérisé en ce que** ledit système d'acquisition d'image est un appareil photographique numérique dont la taille d'un pixel est inférieure ou égale à 0,25 $\mu$m.

4. Procédé selon l'une des revendications 1 à 3, **caractérisé en ce que** l'ouverture numérique du système d'acquisition d'image est supérieure ou égale à 0,8.

5. Procédé selon l'une des revendications 1 à 4, **caractérisé en ce que** l'incidence du flux lumineux sur la surface de la structure est normale à ladite surface.

6. Procédé selon l'une des revendications 1 à 5, **caractérisé en ce que** ledit traitement comprend un calcul d'une réflectivité théorique de la structure multicouche en fonction de l'épaisseur de ladite couche à mesurer pour la longueur d'onde du flux lumineux quasi-monochromatique et la détermination, à partir dudit calcul, d'une cartographie des variations d'épaisseur de ladite couche.

**7.** Procédé selon l'une des revendications 1 à 5, **caractérisé en ce que** ledit traitement comprend :

- la comparaison de l'image avec une courbe de calibration préalablement établie, ladite courbe de calibration fournissant une relation entre des niveaux de gris de l'image acquise et une épaisseur locale de ladite couche à mesurer, et
- la détermination, à partir de ladite courbe de calibration, d'une cartographie des variations d'épaisseur de la couche sur la surface de la structure.

**8.** Procédé selon l'une des revendications 1 à 7, **caractérisé en ce qu'**il comprend, préalablement à l'acquisition de ladite au moins une image, les étapes suivantes :

- mesure de l'épaisseur de chacune des couches de la structure,
- à partir de ladite épaisseur mesurée, simulation de la sensibilité de la réflectivité par rapport à chacune desdites couches en fonction de la longueur d'onde d'un flux lumineux incident, et
- détermination, à partir de ladite simulation, de la longueur d'onde du flux lumineux quasi-monochromatique destiné à illuminer la surface de la structure, ladite longueur d'onde étant choisie de sorte à minimiser la sensibilité de la réflectivité par rapport à une couche autre que la couche à mesurer.

**9.** Procédé selon la revendication 8, **caractérisé en ce que** ladite mesure d'épaisseur est réalisée au moyen d'un ellipsomètre ou d'un réflectomètre.

**10.** Procédé selon l'une des revendications 1 à 9, **caractérisé en ce que** la structure multicouche est une structure constituée de deux couches transparentes à la longueur d'onde du flux lumineux quasi-monochromatique sur un substrat support.

**11.** Procédé selon l'une des revendications 1 à 10, **caractérisé en ce que** ladite structure multicouche est une structure semi-conducteur sur isolant comprenant un substrat support, une couche électriquement isolante et une couche semi-conductrice et **en ce que** la couche dont on mesure les variations d'épaisseur est ladite couche semi-conductrice.

**12.** Procédé selon la revendication 11, **caractérisé en ce que** ladite structure est une structure FDSOI, la couche dont on mesure les variations d'épaisseur étant une couche de silicium présentant une épaisseur inférieure ou égale à 50 nm, de préférence inférieure ou égale à 12 nm.

**13.** Système de mesure des variations d'épaisseur d'une couche d'une structure semi-conductrice multicouche, **caractérisé en ce qu'**il comprend :

- un dispositif d'éclairage de la structure, adapté pour émettre un flux lumineux quasi-monochromatique en direction de la surface de ladite structure,
- un dispositif de sélection de la longueur d'onde du flux lumineux quasi-monochromatique configuré pour déterminer une longueur d'onde correspondant à un minimum de la sensibilité de la réflectivité par rapport à une couche de la structure autre que la couche dont les variations d'épaisseur doivent être mesurées, ladite sensibilité de la réflectivité par rapport à une couche étant égale au rapport entre :

- la différence entre les réflectivités de deux structures multicouches pour lesquelles la couche considérée présente une différence d'épaisseur donnée et
- ladite différence d'épaisseur donnée,
les épaisseurs des autres couches étant quant à elles identiques dans les deux structures multicouches, ledit dispositif de sélection étant couplé au dispositif d'éclairage pour fournir audit dispositif d'éclairage ladite longueur d'onde déterminée du flux lumineux à émettre,

- un système d'acquisition d'image agencé de sorte à acquérir au moins une image de la surface de la structure par réflexion dudit flux lumineux quasi-monochromatique,
- un système de traitement configuré pour, à partir de ladite au moins une image acquise, déterminer, à partir des variations d'intensité de la lumière réfléchie par ladite surface, les variations de l'épaisseur de ladite couche à mesurer.

14. Système selon la revendication 13, **caractérisé en ce que** le dispositif d'éclairage comprend une source de lumière blanche et une roue supportant une pluralité de filtres présentant des longueurs d'onde différentes, la roue étant adaptée pour tourner de sorte que la lumière émise par ladite source passe au travers d'un filtre présentant la longueur d'onde déterminée par le dispositif de sélection avant d'atteindre la surface de la structure à mesurer.

15. Système selon la revendication 13, **caractérisé en ce que** le dispositif d'éclairage comprend une pluralité de sources lumineuses présentant chacune une longueur d'onde différente et une pluralité d'obturateurs amovibles couplés auxdites sources et agencés de sorte à ne laisser passer que la lumière présentant la longueur d'onde déterminée par le dispositif de sélection vers la surface de la structure à mesurer.

**Patentansprüche**

1. Verfahren zur Dickenvariationsmessung einer Schicht einer mehrschichtigen Halbleiterstruktur, **dadurch gekennzeichnet, dass** es Folgendes umfasst:

   - die Erfassung von mindestens einem Bild der Fläche der Struktur durch ein Bilderfassungssystem, wobei das Bild durch Reflexion eines beinahe monochromatischen Lichtstroms auf der Fläche der Struktur erhalten wird,
   - die Verarbeitung des mindestens einen erfassten Bildes, derart, dass die zu messenden Variationen der Dicke der Schicht ausgehend von den Variationen der Stärke des durch die Fläche reflektierten Lichts bestimmt werden,

   und dadurch, dass die Wellenlänge des beinahe monochromatischen Lichtstroms derart ausgewählt wird, dass sie einem Minimum der Empfindlichkeit des Reflexionsvermögens in Bezug zu einer Schicht der Struktur entspricht, die sich von der Schicht unterscheidet, deren Dickenvariationen gemessen werden müssen, wobei die Empfindlichkeit des Reflexionsvermögens in Bezug zu einer Schicht gleich dem Verhältnis zwischen Folgendem ist:

   - der Differenz zwischen den Reflexionsvermögen von zwei mehrschichtigen Strukturen, für die die betrachtete Schicht eine gegebene Dickendifferenz aufweist, und
   - der gegebenen Dickendifferenz,

   wobei, was die Dicken der anderen Schichten betrifft, diese in den zwei mehrschichtigen Strukturen identisch sind.

2. Verfahren nach Anspruch 1, **dadurch gekennzeichnet, dass** das Bilderfassungssystem ein Lichtmikroskop ist.

3. Verfahren nach Anspruch 1, **dadurch gekennzeichnet, dass** das Bilderfassungssystem ein digitaler Fotoapparat ist, bei dem die Größe eines Pixels kleiner oder gleich 0,25 $\mu$m ist.

4. Verfahren nach einem der Ansprüche 1 bis 3, **dadurch gekennzeichnet, dass** die numerische Apertur des Bilderfassungssystems größer oder gleich 0,8 ist.

5. Verfahren nach einem der Ansprüche 1 bis 4, **dadurch gekennzeichnet, dass** der Einfall des Lichtstroms auf der Fläche der Struktur normal zu der Fläche ist.

6. Verfahren nach einem der Ansprüche 1 bis 5, **dadurch gekennzeichnet, dass** die Verarbeitung eine Berechnung eines theoretischen Reflexionsvermögens der mehrschichtigen Struktur in Abhängigkeit von der zu messenden Dicke der Schicht für die Wellenlänge des beinahe monochromatischen Lichtstroms und die Bestimmung einer Kartographie der Dickenvariationen der Schicht ausgehend von der Berechnung umfasst.

7. Verfahren nach einem der Ansprüche 1 bis 5, **dadurch gekennzeichnet, dass** die Verarbeitung Folgendes umfasst:

   - den Vergleich des Bildes mit einer vorhergehend erstellten Kalibrierkurve, wobei die Kalibrierkurve eine Beziehung zwischen den Graustufen des erfassten Bildes und einer lokalen Dicke der zu messenden Schicht liefert, und
   - die Bestimmung einer Kartographie der Dickenvariationen der Schicht auf der Fläche der Struktur ausgehend von der Kalibrierungskurve.

8. Verfahren nach einem der Ansprüche 1 bis 7, **dadurch gekennzeichnet, dass** es vor der Erfassung des mindestens einen Bildes die folgenden Schritte umfasst:

- Messung der Dicke von jeder der Schichten der Struktur,
- ausgehend von der gemessenen Dicke, Simulation der Empfindlichkeit des Reflexionsvermögens in Bezug zu jeder der Schichten in Abhängigkeit von der Wellenlänge eines einfallenden Lichtstroms, und
- Bestimmung der Wellenlänge des beinahe monochromatischen Lichtstroms, der dazu bestimmt ist, die Fläche der Struktur zu beleuchten, ausgehend von der Simulation, wobei die Wellenlänge derart gewählt ist, dass die Empfindlichkeit des Reflexionsvermögens in Bezug auf eine Schicht, die sich von der zu messenden Schicht unterscheidet, minimiert wird.

9. Verfahren nach Anspruch 8, **dadurch gekennzeichnet, dass** die Messung der Dicke mittels eines Ellipsometers oder eines Reflektometers ausgeführt wird.

10. Verfahren nach einem der Ansprüche 1 bis 9, **dadurch gekennzeichnet, dass** die mehrschichtige Struktur eine Struktur ist, die aus zwei gegenüber der Wellenlänge des beinahe monochromatischen Lichtstroms durchlässigen Schichten auf einem Trägersubstrat besteht.

11. Verfahren nach einem der Ansprüche 1 bis 10, **dadurch gekennzeichnet, dass** die mehrschichtige Struktur eine Halbleiterstruktur auf Isolierstoff ist, die ein Trägersubstrat, eine elektrisch isolierende Schicht und eine Halbleiterschicht umfasst, und dadurch, dass die Schicht, deren Dickenvariationen gemessen werden, die Halbleiterschicht ist.

12. Verfahren nach Anspruch 11, **dadurch gekennzeichnet, dass** die Struktur eine FDSOI-Struktur ist, und die Schicht, deren Dickenvariationen gemessen werden, eine Siliziumschicht ist, die eine Dicke aufweist, die kleiner oder gleich 50 nm, vorzugsweise kleiner oder gleich 12 nm, ist.

13. System zur Messung der Dickenvariationen einer mehrschichtigen Halbleiterstruktur, **dadurch gekennzeichnet, dass** es Folgendes umfasst:

- eine Vorrichtung zur Beleuchtung der Struktur, die angepasst ist, um einen beinahe monochromatischen Lichtstrom in Richtung der Fläche der Struktur zu emittieren,
- eine Vorrichtung zur Auswahl der Wellenlänge des beinahe monochromatischen Lichtstroms, die ausgestaltet ist, um eine Wellenlänge zu bestimmen, die einem Minimum der Empfindlichkeit des Reflexionsvermögens in Bezug zu einer Schicht der Struktur entspricht, die sich von der Schicht unterscheidet, deren Dickenvariationen gemessen werden müssen, wobei die Empfindlichkeit des Reflexionsvermögens in Bezug zu einer Schicht gleich dem Verhältnis zwischen Folgendem ist:

- der Differenz zwischen den Reflexionsvermögen von zwei mehrschichtigen Strukturen, für die die betrachtete Schicht eine gegebene Dickendifferenz aufweist, und
- der gegebenen Dickendifferenz,
wobei, was die die Dicken der anderen Schichten betrifft, diese in den zwei mehrschichtigen Strukturen identisch sind,
wobei die Vorrichtung zur Auswahl an eine Beleuchtungsvorrichtung gekoppelt ist, um der Beleuchtungsvorrichtung die bestimmte Wellenlänge des zu emittierenden Lichtstroms zu liefern,

- ein Bilderfassungssystem, das derart angeordnet ist, um mindestens ein Bild der Fläche der Struktur durch Reflexion des beinahe monochromatischen Lichtflusses zu erfassen,
- ein Verarbeitungssystem, das ausgestaltet ist, um ausgehend von dem mindestens einen erfassten Bild, ausgehend von den Variationen der Stärke des durch die Fläche reflektierten Lichts die Dickenvariationen der zu messenden Schicht zu bestimmen.

14. System nach Anspruch 13, **dadurch gekennzeichnet, dass** die Beleuchtungsvorrichtung eine Weißlichtquelle und ein Rad umfasst, das mehrere Filter trägt, die verschiedene Wellenlängen aufweisen, wobei das Rad angepasst ist, um sich derart zu drehen, dass das durch die Quelle emittierte Licht vor dem Erreichen der Fläche der zu messenden Struktur ein Filter durchquert, das die durch die Auswahlvorrichtung bestimmte Wellenlänge aufweist.

**15.** System nach Anspruch 13, **dadurch gekennzeichnet, dass** die Beleuchtungsvorrichtung mehrere Lichtquellen, die jeweils eine unterschiedliche Wellenlänge aufweisen, und mehrere abnehmbare Verschlüsse umfasst, die an die Quellen gekoppelt sind und derart angeordnet sind, dass sie einzig das Licht, das die durch die Auswahlvorrichtung bestimmte Wellenlänge aufweist, in Richtung der Fläche der zu messenden Struktur durchlässt.

**Claims**

**1.** A method for measuring thickness variations in a layer of a multilayer semiconductor structure, **characterized in that** it comprises:

- acquiring, with an image acquisition system, at least one image of the surface of said structure, said image being obtained by reflecting a quasimonochromatic light flux on the surface of said structure,
- processing said at least one acquired image so as to determine, from the intensity variations of the light reflected by said surface, the thickness variations of said layer to be measured,

and **in that** the wavelength of said quasimonochromatic light flux is selected so as to correspond to a minimum of the sensitivity of the reflectivity with respect to a layer of the structure other than the layer for which the thickness variations have to be measured, said sensitivity of the reflectivity with respect to a layer being equal to the ratio between:

- the difference between the reflectivities of two multilayer structures for which the considered layer has a given thickness difference and
- said given thickness difference,

the thicknesses of the other layers being identical in both multilayer structures.

**2.** The method according to claim 1, **characterized in that** said image acquisition system is an optical microscope.

**3.** The method according to claim 1, **characterized in that** said image acquisition system is a digital camera for which the size of a pixel is less than or equal to 0.25 $\mu$m.

**4.** The method according to one of claims 1 to 3, **characterized in that** the numerical aperture of the image acquisition system is greater than or equal to 0.8.

**5.** The method according to one of claims 1 to 4, **characterized in that** the incidence of the light flux on the surface of the structure is normal to said surface.

**6.** The method according to one of claims 1 to 5, **characterized in that** said processing comprises a computation of a theoretical reflectivity of the multilayer structure depending on the thickness of said layer to be measured for the wavelength of the quasimonochromatic light flux and the determination, from said computation, of a mapping of the thickness variations of said layer.

**7.** The method according to one of claims 1 to 5, **characterized in that** said processing comprises:

- comparing the image with a calibration curve established beforehand, said calibration curve providing a relationship between grey levels of the acquired image and a local thickness of said layer to be measured, and
- determining from said calibration curve, a mapping of the thickness variations of the layer on the surface of the structure.

**8.** The method according to one of claims 1 to 7, **characterized in that** it comprises, before acquiring said at least one image, the following steps:

- measuring the thickness of each of the layers of the structure,
- from said measured thickness, simulating the sensitivity of the reflectivity with respect to each of said layers versus the wavelength of an incident light flux, and
- determining, from said simulation, the wavelength of the quasi-monochromatic light flux intended to illuminate the surface of the structure, said wavelength being selected so as to minimize the sensitivity of the reflectivity with respect to a layer other than the layer to be measured.

9. The method according to claim 8, **characterized in that** said thickness measurement is conducted by means of an ellipsometer or a reflectometer.

10. The method according to one of claims 1 to 9, **characterized in that** the multilayer structure is a structure consisting of two layers transparent to the wavelength of the quasi-monochromatic light flux on a supporting substrate.

11. The method according to one of claims 1 to 10, **characterized in that** said multilayer structure is a semiconductor-on-insulator structure comprising a supporting substrate, an electrically insulating layer and a semiconducting layer and **in that** the layer for which the thickness variations are measured is said semiconducting layer.

12. The method according to claim 11, **characterized in that** said structure is an FDSOI structure, the layer for which the thickness variations are measured being a silicon layer having a thickness of less than or equal to 50 nm, preferably less than or equal to 12 nm.

13. A system for measuring thickness variations in a layer of a multilayer semiconductor structure, **characterized in that** it comprises:

- a device for illuminating the structure, adapted for emitting a quasi-monochromatic light flux towards the surface of said structure,
- a device for selecting the wavelength of the quasi-monochromatic light flux, configured for determining a wavelength corresponding to a minimum of the sensitivity of the reflectivity with respect to a layer of the structure other than the layer for which the thickness variations have to be measured, said sensitivity of the reflectivity with respect to a layer being equal to the ratio between:

- the difference between the reflectivities of two multilayer structures for which the considered layer has a given thickness difference, and
- said given thickness difference,
the thicknesses of the other layers being identical in both multilayer structures,
said selection device being coupled with the illumination device so as to provide said illumination device with said determined wavelength of the light flux to be emitted,

- an image acquisition system laid out so as to acquire at least one image of the surface of the structure by reflection of said quasi-monochromatic light flux,
- a processing system configured for, from said at least one acquired image, determining from the intensity variations of the light reflected by said surface, the variations of the thickness of said layer to be measured.

14. The system according to claim 13, **characterized in that** the illumination device comprises a source of white light and a wheel supporting a plurality of filters having different wavelengths, the wheel being adapted so as to rotate so that the light emitted by said source passes through a filter having the wavelength determined by the selection device before attaining the surface of the structure to be measured.

15. The system according to claim 13, **characterized in that** the illumination device comprises a plurality of light sources each having a different wavelength and a plurality of removable obturators coupled with said sources and laid down so as to only let through the light having the wavelength determined by the selection device towards the surface of the structure to be measured.

## FIG. 1

## FIG. 2

## FIG. 3

## FIG. 4

## FIG. 5A

## FIG. 5B

## FIG. 5C

## FIG. 5D

EP 2 917 688 B1

## FIG. 6

## FIG. 7

## RÉFÉRENCES CITÉES DANS LA DESCRIPTION

**Documents brevets cités dans la description**

- EP 2426717 A
- US 5402001 A